**Europäisches Patentamt**

(19) **European Patent Office**

**Office européen des brevets**

(11) Publication number: **0 176 557**
**B1**

(12) **EUROPEAN PATENT SPECIFICATION**

(45) Date of publication of patent specification: **30.01.91**

(51) Int. Cl.⁵: **H 01 L 23/50, H 01 P 1/26, H 01 P 3/08, H 01 P 5/00**

(21) Application number: **85901783.2**

(22) Date of filing: **19.03.85**

(86) International application number:
**PCT/US85/00456**

(87) International publication number:
**WO 85/04522 10.10.85 Gazette 85/22**

(54) **IMPEDANCE-MATCHED LEADS.**

(30) Priority: **22.03.84 US 592160**

(43) Date of publication of application:
**09.04.86 Bulletin 86/15**

(45) Publication of the grant of the patent:
**30.01.91 Bulletin 91/05**

(84) Designated Contracting States:
**DE FR GB NL**

(56) References cited:
**EP-A-00 726 44**
**WO-A-81/03396**
**JP-A-54 132 166**
**JP-A-57 459 40**
**US-A-3 628 105**

**PATENT ABSTRACTS OF JAPAN, vol. 6, no. 243 (E-145)1121r, 2nd December 1982; & JP-A-57 141 946**

(73) Proprietor: **SGS-THOMSON MICROELECTRONICS, INC. (a Delaware corp.)**
**1310 Electronics Drive**
**Carrollton, TX 75006 (US)**

(72) Inventor: **QUINN, Daniel, J.**
**2051 Kings Road**
**Carrollton, TX 75007 (US)**
Inventor: **MULHOLLAND, Wayne, A.**
**4437 Denver Drive**
**Plano, TX 75075 (US)**

(74) Representative: **Driver, Virginia Rozanne et al**
**Page White & Farrer 54 Doughty Street**
**GB-London WC1N 2LS (GB)**

Courier Press, Leamington Spa, England.

# Description

## Technical field

The field of the invention is that of attaching electrical leads to integrated circuit chips.

## Background art

The present method of attaching integrated ciruits to leads is by wire-bonding, in which a narrow wire having a diameter on the order of $2.54 \times 10^{-6}$ cms (1 mil) is used to join the relatively wide leadframe to the integrated circuit chip. Such a narrow diameter wire, of course, has a high inductance associated with it and the impedance mismatch between the wire and the leadframe gives rise to reflections an also to a bandwidth limitation.

US—A—3 628 105 shows integrated circuit devices operating in the ultra-high frequency ranges in which each lead is formed of a strip line comprising conductors separated by a dielectric whereby the characteristic impenance of the lead is matched with that of the integrated circuit to prevent signal reflection.

## Disclosure of the invention

The invention relates to an integrated circuit lead that is constructed to have a specified impedance.

A feature of the invention is the matching of the lead impedance to the impedance of a socket or other connector to which the lead is connected.

Another feature of the invention is the provision of a terminating resistor at the interface of the lead and the chip contact.

Another feature of the invention is the fabrication of a lead made from a laminated sandwich of a dielectric between two conductors.

## Brief description of drawings

Figure 1 illustrates the process flow in the subject invention.

Figure 2 illustrates the steps in Figure 1 in more detail.

Figures 3A through 3B illustrate different forms of a chip used in the subject invention.

Figure 4A and 4B illustrated chips with different arrays of contact pads.

Figure 5 illustrates a portion of a leadframe.

Figure 6 illustrates a cross section of an integrated circuit suitable for use with the invention.

Figure 7 illustrates a carrier used to hold a leadframe and die during the bonding step.

Figures 8A—8C illustrate a leadframe design suitable for 16-pin dice.

Figures 9A and 9B illustrate a gripper mechanism for the leadframes.

Figures 10A and 10B illustrate an alternate leadframe having a specified impedance.

Figure 11 illustrates a portion of the leadframe of Figure 10.

Figure 12 illustrates a simplified optical inspection device for lead frame to die bonds.

## Best mode for carrying out the invention

The present invention was developed together with other components of a system of assembling and testing integrated circuits. In order to convey the invention in context, discussion of the overall system is included in this specification.

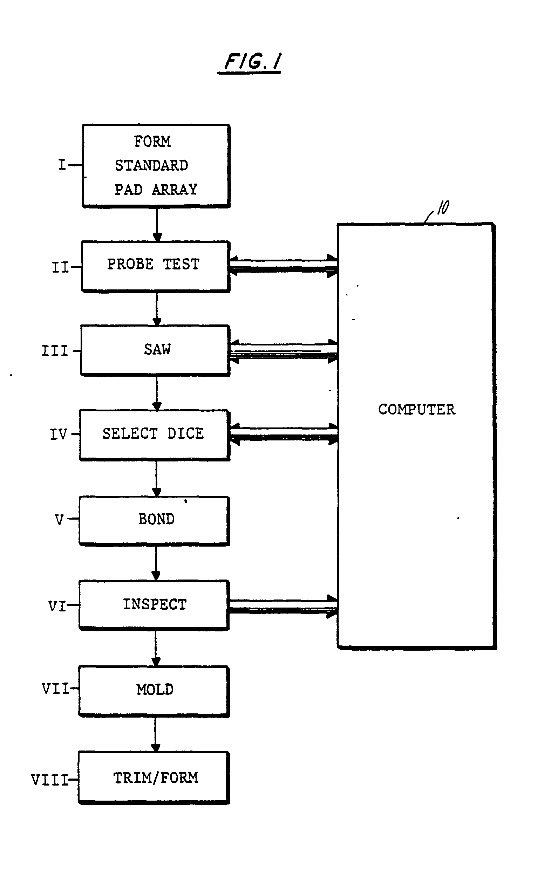

An overall flow chart of the steps used in the back-end assembly is illustrated in Figure 1, in which a number of steps are illustrated schematically and are performed by a variety of different machines in communication with and sometimes controlled by a computer for storing test and other data.

In the first major step, represented by the box labelled I, a process that may be part of the "front-end" or the "back-end", accepts as input a wafer that has been completed with all the conventional steps (including passivation - etc.) and applies a further layer of dielectric having a thickness sufficient to protect the chip circuits and to insulate them electrically from signals being carried on the top surface of the dielectric.

A pattern of metal leads is formed that extends from the contact pads on the previous chip to a standard array of contact pads on the top of the dielectric. The standard array is the same for all chips having the same number of pins, regardless of the size of the chip die.

The wafer is then probe tested, in major step II with the results of the probe test being stored electrically, such as in a computer. The conventional ink-dot marking system for bad chips is not used.

The wafer is then adhesively mounted on an adhesive film in a frame holder that is shaped to allow for automatic inserting and orientation in various fixtures further along in the process and cut apart in an automatic sawing process (Step III) that cuts through the entire thickness of the wafer.

The good dice are then removed from the wafer in an automatic sequence (Step IV) that presses from above against the tape to selectively pick a die down into a dedicated carrier where it rests circuit side down. This is not a problem since the active circuitry is protected by the standard pad dielectric and standard pads. The wafer and punch-out device are moved under computer control to put the dice into the correct positions in the carrier.

The dice are transferred to a mating carrier simultaneously in an inversion operation that rotates the two-carrier "sandwich" by 180 degrees, so that the dice resting in the second carrier have contacts on the top side. A set of dice are transferred to a bonding fixture that holds a convenient number, illustratively 14 dice. Once loading is complete, a leadframe matching the spacing of the dice in the fixture is positioned above the dice in the soldering fixture and an upper bonding fixture is added to maintain lead to pad contact during the bonding process.

The bonding fixture is heated to reflow the solder and form the interconnection (Step V).

The leadframe with dice attached is placed in a transfer or injection molding machine that encapsulates the die together with the interconnections to the leadframe (Step VI).

The molded strip of devices is then trimmed and formed conventionally (Step VII).

There is a representation in Figure 1 of data communication between the machines that perform the steps listed above and the controlling computer. Most data communication steps are optional. The step may indeed be performed under operator control and data may be written down manually. The benefits of automatic recording of data and error-free recall of data from a previous step will be evident to those skilled in the art.

The different steps of the invention are set forth in more detail below and in copending patent applications filed on the same date herewith and assigned to the assignee hereof.

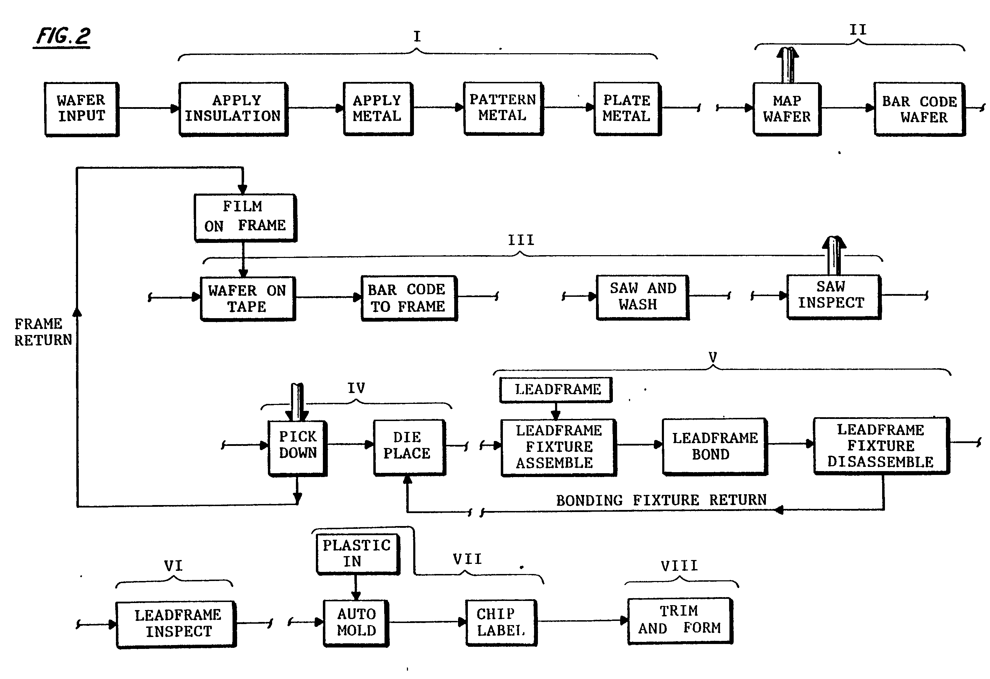

Figure 2 sets out the steps in Figure 1 in more detail and also illustrates the material and data flow. A convention used in this figure is that a broken line indicates a material transport step of the sort of loading the material into a container and moving the container to another location and a double arrow indicates data flow into or out of a computer or other storage device. The three material inputs to the process are the wafers, leadframes and plastic for encapsulation. Two recirculation loops involve, respectively, a frame used to support the wafers during the sawing and die selection steps and a positioning fixture used to maintain a set of dice in alignment with a leadframe segment during the bonding operation.

Standard contact pads

Returning to the first major step, the illustrative dielectric layer is a polyimide such as Dupont 2525 applied with the thickness of 6 microns and cured at a temperature of greater than 260 C. There may be a nitride or other layer below the polyimide to improve adhesion to the reflow glass or other top layer. The electrical contact pads that have been previously formed in the integrated circuit chip by conventional processing techniques are exposed by applying a photoresist, either liquid or in the form of a tape, on top of the dielectric and etching down through it a passageway to the metal contact pad in the circuit in a conventional manner. A "via" will be formed by filling the contact holes with a metal or other conductor until the surface of the dielectric is reached. The photoresist is stripped off and a layer of metal is applied by any technique, such as sputtering, over the surface of the polyimide. In one example, the polyimide was back sputtered to prepare the surface, after which 600 Angstroms of 10% titanium +90% tunsten followed by 1000 Angstroms of copper and titanium-tunsten sputtered simultaneously, followed by typically 3 microns of copper were sputtered on. A second layer of photoresist is applied and patterned to define a set of metal leads in the metal layer. The leads reach from the vias penetrating the dielectric to an area in the center of the chip which has a standard pad array of pad contacts that is the same for all the chips that have the same number of leads. For example, a 16 pin chip will have the same standard pad array, of size about .016" by .016" in a standard configuration having dimensions of .126" by .126", whether it is a memory or any other logic device. The standard pad array will be sized so that it fits on the smallest chip that is to be used with that leadframe. Optional versions of the invention employ a pad array that is arranged for some particular purpose.

The exposed areas of the metal are plated with a solder composed of a standard mixture of lead and tin in a conventional electrolytic plating process that employs a mixture of 95% tin and 5% lead. The photoresist is stripped and the plated areas of the metal layer are used as an etching mask in the next step in which the remaining unwanted area of the metal layer is etched away in a bath of hydrogen peroxide plus ammonium hydroxide followed by hydrogen peroxide, which does not attack the solder.

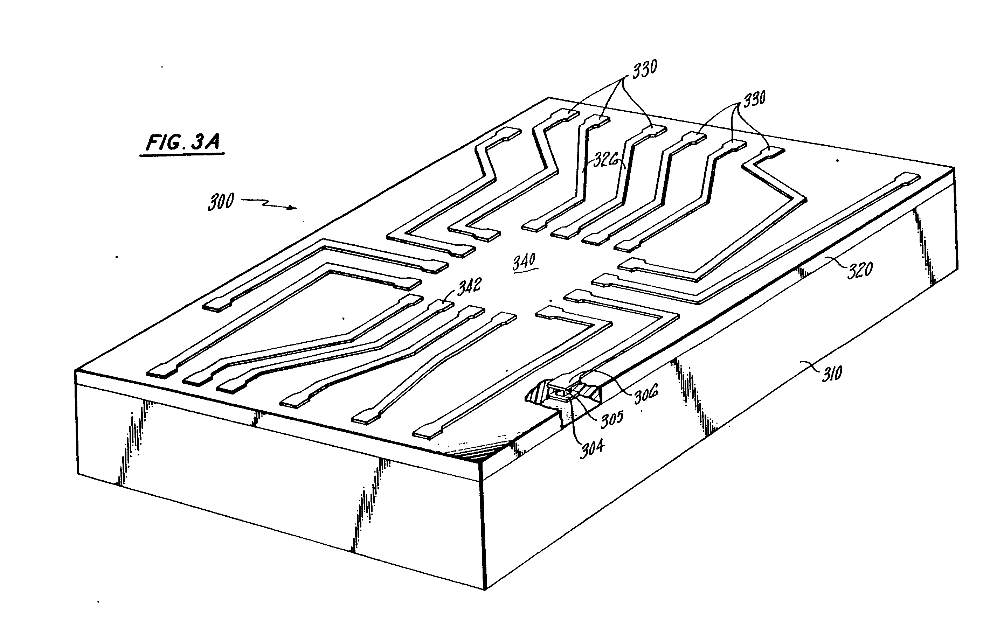

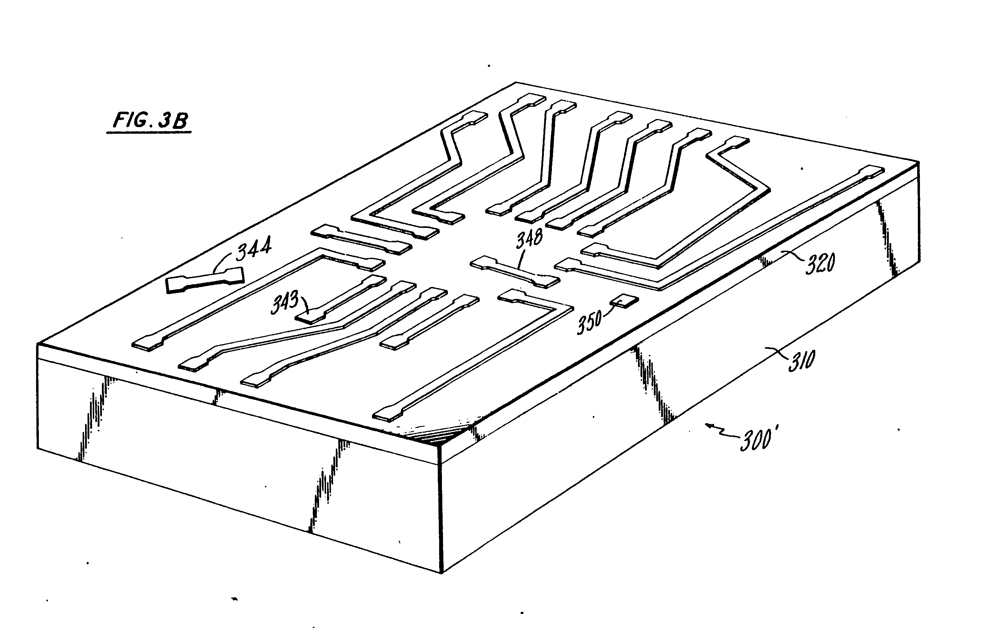

There now remains a chip 300 of the form illustrated in Figure 3A, in which die 310 has on it a thick layer of polyimide 320 and a newwork of metal lines 326 leading from the contact areas 330 on the outside of the chip to the standard pad array 340. The metal lines 326 have lower inductance greater thermal conductivity and greater strength compared to the wires that were previously used.

In the example shown in Figure 3A, the first contacts and the vias through the polyimide layer are all formed on the perimeter of the chip. This figure illustrates a chip in which the layout design was made for the old wire-bonding method in which the contact areas had to be on the perimeter of the chip. An advantage of retaining the old design, besides saving the expense of a new layout, is that it is possible to use conventional wirebonding processes when added capacity is required. To do this however, requires that the additional dielectric and metallizations for the standard pad process is not used.

It is also possible to use the invention and put the contact areas through the dielectric at any convenient location, as shown in Figure 3B. The vias for these leads are shown as originating at different locations on the chip surface, not exclusively at the edge as was the case in the prior art. Lead 348 is shown as connecting a via that is located within the standard pay array. Lead 343 is connected to a via-section 344 through a bridge, not shown in the drawing, that is placed on top of the passivation layer of the underlying chip below the polyimide. This illustrates an additional degree of freedom in routing leads and placing components that is provided by the invention.

A via 305 is shown in Figure 3A in a cut-away portion of the figure as extending from a lower contact area 304 to an upper contact 306 at an end of one of leads 326. The lower contact pads in current practice are typically 0.1 millimeter by 0.1 millimeter (4 mils by 4 mils). With such a large area to make contact, the alignment tolerance for the formation and location of the vias and the placement of leads 326 are typically ± .05 millimeter to .15 millimeter (2 mils to 3 mils), which is much greater than a typical tolerance of ± 12.5 millimeters to 25 millimeters (1/2 mil to 1 mil) for connecting leads in the precision processes that are used with conventional wirebonding.

The steps of forming vias and putting down leads may be performed in the front-end using the standard machines for photolithography, if that is convenient. Since the requirements for putting down these metal leads are much less stringent in position alignment than the usual front-end work, it may be preferable to use thick-film technology, such as screen printing, to pattern the dielectric and top leads. Typically, the thick-film technique will be 1/4 to 1/2 the cost of the precision techniques.

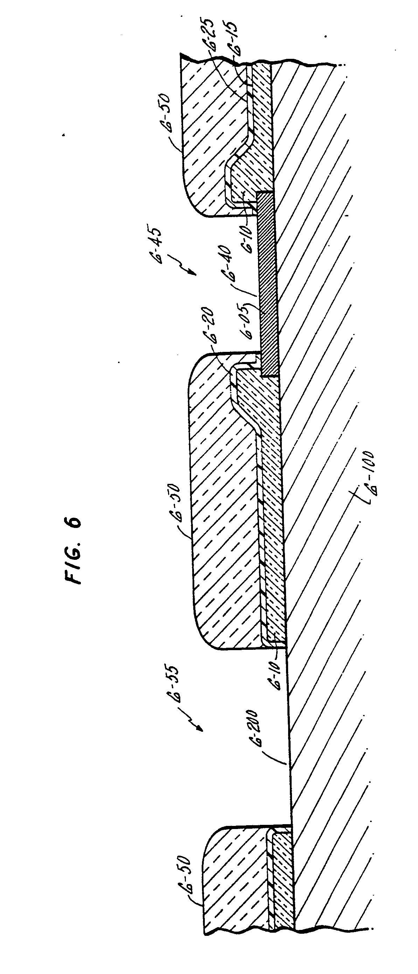

It has been found that the polyimide layer 320 of Figure 3 does not adhere reliably if it is attached directly to the layer of oxide immediately below it. A cross section of a portion of a die is shown in Figure 6, in which substrate 6—100 is the silicon substrate and aperture 6—200 is the "street" that separates adjacent dice. The width of a street is typically 100 micrometers, to allow room for the saw kerf in the separation step that is performed with a diamond saw having a width of 25 micrometers (.001 inch).

A contact pad, 6—05, is shown with a series of apertures defined above it. Pad 6—05, which is typically aluminum and is connected by metallization strips, not shown, to the rest of the circuit, is surrounded by oxide 6—10, which has a conventional composition of $SiO_2$ plus phosphorous and other additives and a thickness of 1 micrometer. Oxide 6—10 has a top surface 6—15 on which polyimide layer 6—50 was, at first, applied directly. Early tests showed significant difficulty, in that polyimide layer 6—50 (layer 320 in Figure 3) often disbonded, causing the leadframe to pull the polyimide away from the underlying layer.

Oxide 6—10 functions as the top dielectric layer in the circuit. It not only coats the substrate and contacts, as shown in Figure 6, but also the circuit elements and metallization.

Pasivation of the active elements of the circuit is effected in the usual manner of silicon MOSFETS by the thin oxide over source, drain and active area so that oxide 6—10 functions purely as a dielectric, not as a passivating layer.

Nitride layer 6—20 is deposited by plasma-assisted CVD at a temperature of 250 C, in a conventional manner, to a thickness of .3 micron after street 6—200 has been etched through oxide 6—10 to the substrate. A layer of 2525 polyimide from Dupont is applied and spun to produce a relatively flat top surface. Apertures 6—45 above contact 6—05 and 6—55 above street 6—200 are opened through the uncured polyimide by wet etching with a conventional basic solution such as Shipley 312 developer. Typical dimensions for the top of aperture 6—55 and 6—45 are 100 and 87 microns, respectively. After aperture 6—45 has been opened, aperture 6—40 is opened through nitride layer 6—20 by plasma etching in CF4. A typical dimension of apperture 6—40 is 75 microns, so that aperture 6—40 is surrounded by nitride 6—20 and does not expose any of oxide 6—10.

It has been found that the adhesion of polyimide to top surface 6—25 of nitride 6—20 is greatly improved over the adhesion of polymide to oxide 6—10 at surface 6—15. Nitride 6—20 adheres well to oxide at surface 6—15, the function of nitride 6—20 is thus to improve the adhesion of the polymide by means of a structure that totally encloses the oxide 6—10, not only at the vias but also at the saw cuts on the streets.

Probe test

The next major step II is a test with the indiviudal circuit dice still remaining in the wafer. A conventional wafer electrical test step could be performed in which small probes are attached to the contacts that will be used for the input/output and the individual chips are tested. An advantage of this invention is that the metal leads on top of the polyimide cover a much larger area than the old-style contact pads do, so that it is easier to make electrical contact at reduced pressure of the electrical contact probe or electrode with these large metal pads than it is with the small contact pads used in conventional techniques. It is also possible to make electrical contact to the leads before you reach the contact area, thus providing additional flexibility in the probe step. An important economic benefit from the invention is that only a single set of probe tips will be needed to match the standard pad array for the whole family of circuits that have the same number of pins. In the prior art, a different set of probe tips was typically needed fbjcech chip design.

If the chip has optional electric contact pads outside the standard pad array, as shown by contact 350 in Figure 3B (which is a via formed to provide access to a point in a circuit that is to be tested, yet does not connect to one of the regular contacts), then a different set of probe pins will be needed in that case, of course.

In conventional wafer tests, defective chips are marked by a small dot of ink so that, in manual assembly, they can be identified and discarded. In this process, the chips are identified electrically i.e. the wafer is oriented in a particular way and the chips are identified by their locations in an X—Y matrix. The test data for individual chips are stored in the central computer memory or in a floppy disk or other storage medium and defective chips are identified in the computer. This step is referred to in Figure 2 as wafer mapping.

If the chip has the feature of redundant or optional circuits that are connected or disconnected by blowing fuses by a laser (as it done in large scale memory arrays), then this step will have been done before the polyimide layer is put down, as is currently being done. It is possible, however, to provide for the enabling or disabling of optional subcircuits or the enabling of redundant circuits to be done electrically by means of access through additional contacts (similar to contact 350) that are placed through the polyimide layer outside of the metal strips, or by putting down the polyimide with a large opening over the redundant circuits that will be closed later. In that case, the central computer would identify optional circuits that are to be enabled or disabled and blow fuses appropriately through the test probes. The point in the sequence at which fuse-blowing is to be done is optional, of course.

If the wafers have not been given an identifying label before, it is now necessary to put a label on them in order to maintain the connection between the test data stored in the computer and the wafer the data came from. There are many ways of doing this correlation, of course, and no particular method is required. One preferred method is to put the identification on an identifying label, such as an optical bar code, that identifies the wafer. Another method is to form a programmable memory in the wafer in which the identities of defective chips may be stored. In that case, the wafer carries with it the necessary information so that there is no problem of getting the wafer separated from the test results.

Bond

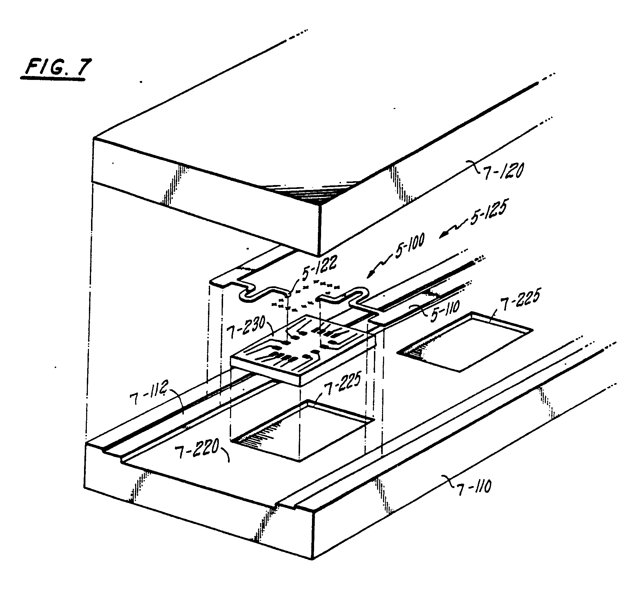

The assembly for the final bonding step (Step V in Figure 1 and Leadframe Fixture Assemble, Bond, Disassemble in Figure 2) is show in an exploded view in Figure 7, in which holder 7—110, represented schematically, holds 14 chips with the correct spacing, only two of the receptacles 7—225 being shown. Above receptacle 7—225, there is positioned chip 7—230 and, above the chip, a set of finger contacts 5—122 in lead frame 5—100, part of leadframe strip 5—125. The details of the leadframe will be described below. Cover 7—120 presses down on edge 5—110 of leadframe strip 5—125, which edges rest on shelves 7—112 to position the outer parts of the strip so that the contact tips will be deflected slightly. This deflection is done to compensate for inevitable fluctuations in the position of the tips during the manufacturing process, so that reliable contact is ensured during the bonding operation. The deflection is effected by making the depth of receptable 7—225 such that the top of chip 7—230 projects above the plane of shelves 7—112 by a set amount. The amount of deflection, (.005 inch to .007 inch) is illustratively several standard deviations of the nominal fluctuation of the tip position to ensure reliable joint formation. The edges 5—110 of leadframe strip 5—125 will be forced on to shelves 7—112 by cover 7—120 and tips 5—122 will thus be pressed against the pads by the spring constant of the leads.

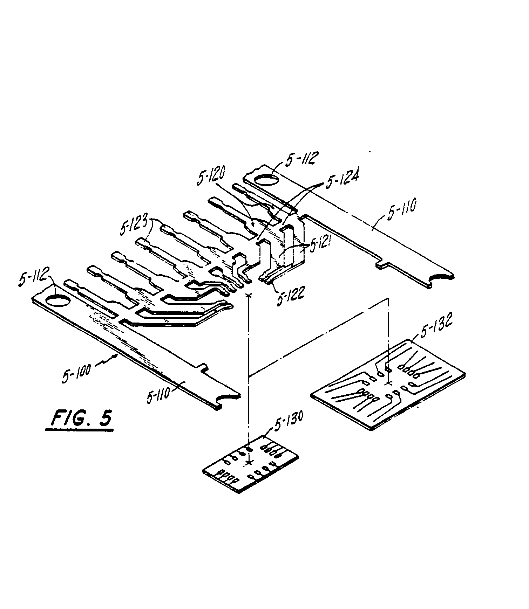

A typical leadframe used in the invention is illustrated in Figure 5, in which half of an individual frame is shown. The individual leadframes are stamped out of a ribbon of metal that may be an inexpensive copper alloy, in contrast to the expensive alloy having the correct thermal properties that is used in the standard prior art process. Strips 5—110 on either side of the ribbon serve to carry the actual leads 5—120 along. Leads 5—120 have an exterior end 5—123, shaped either for insertion in a socket or for surface-mounting, and an interior portion 5—121 for attachment to a die. The two portions are joined by segments 5—124 that will be severed after the bonding step. Holes 5—112 are provided to give a reference in positioning the leadframe. At the end of each lead segment 5—121, there is a region, 5—122, in which the lead is bent in a quarter circle (or bent twice to form a parallel contact section) to form a standard dimension flat contact area. Each of the different lead segments 5—121, with its different length, has been shaped to provide substantially the same spring constant so that the contact areas 5—122 will be uniformly pressed against the mating pads on the die to give correct alignment for the soldering operation. The leads 5—120 have been tinned with solder in a previous step in the fabrication of the lead frame ribbon.

It is an advantageous feature of the system, but not an essential one, that a family of chips that have the same number of pins have the same standard pad array on top of the dielectric. For illustration, two dice 5—130 and 5—132 of different size are shown together with the leadframe. With this feature, it will then be necessary to have only one ribbon of leadframes for the entire family of chips, with substantial savings in inventory.

Both the contact pads 342 of the die and the tips 5—122 have been tinned and are ready to be heated. The bonding is done by a vapor phase reflow soldering technique or other means of heating the materials to reflow the fusible alloys. These alternative techniques include infra-red heating, conveyor ovens, hot gas heating or laser heating. In vapor phase reflow, a liquid such as Flourinert FC—71 is maintained at its boiling point, the liquid having been selected so that its boiling point is above the soldering temperature. The soldering assembly of holders 7—110 and 7—120, with chips plus leadframe maintained in alignment, is inserted into a container or oven that is filled with the vapor at the boiling-point temperature and held there until the solder has melted and flowed to form a bond. A typical length of time for the heating cycle is 5 to 15 seconds. This boiling point temperature is typically above 225 degrees C but below 300 degrees C. In contrast, the present wire bonding and die attach steps are performed at temperatures of up to 460 degrees C and performed individually. In order to reduce the length of the heating cycle, the bonding fixture should have low mass and many apertures to permit the vapor to flow freely about the solder joints. Holders 7—110 and 7—120 have been shown schematically in order to reduce the complexity of the drawing.

An important economic benefit of this invention is that all the leads are soldered at the same time.

This is in contrast to the wire-bonding technique, in which the leads must be bonded one by one. The soldering step takes no longer for a 28 pin chip than it does for a 16 pin chip.

Inspect

The next stage (Step VI in Figure 1) of the assembly sequence is an optional inspection operation in which the mechanical and electrical integrity of the solder bonds is checked. There are may testing mechanisms known in the art, such as pulling on the chip to test the mechanical strength of the joint; placing probes on the edge of the standard pad and the leadframe to test for electrical continuity; or optically examing the lump of solder.

The apparatus illustrated in simplified form in Figure 12 is an optical test, in which the leadframe strip is taken from holder 7—110 and presented for inspection as an intermediate step in the process of loading a cassette for transport to the molding station. Optical source 12—2, illustratively a semiconductor diode or semiconductor laser, generates a beam 12—4 that passes through power monitoring device 12—3 that measures the input beam power. Beam 12—4 strikes the solder lump 12—10 at lead tip 5—122 and reflects in several directions, the exact distribution of reflected power being dependent on the detailed shape of the solder lump and therefore varying from chip to chip. Two detectors 12—13 and 12—15 detect some of the reflected light. Preferably, these detectors have sufficient area to integrate out small fluctuations in the intensity distribution. If lead tip 5—122 did not make contact with the pad, there will be a gap instead of a smooth solder surface and very little light will be reflected. In order to pass the test, both detectors 12—15 and 12—13 must receive a certain fraction of the signal in monitor 12—3. The threshold will be set empirically when the production line is initially put into operation.

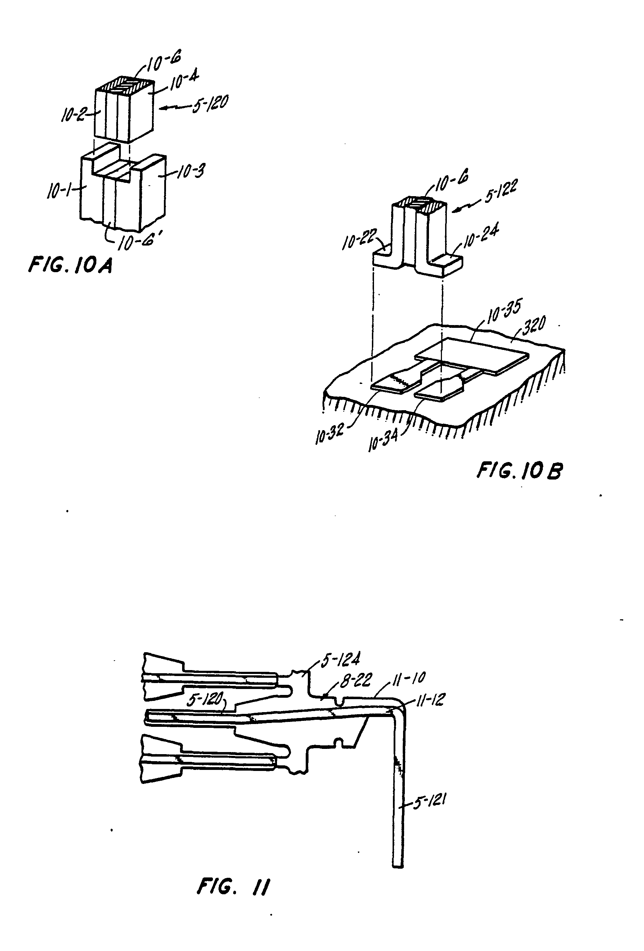

All leads on all 14 chips may be tested; only one lead per 14-chip unit may be tested; or anything in between. The number of tests will depend on the usual cost/reliability trade-offs. One suitable method is for the robot of Figure 10 to move the leadframe strip at a fixed speed past beam 12—11. The signals in detectors 12—15 and 12—13 are sampled when beam 12—11 strikes the point where a bond should be. The individual bonds are thus identified by the time at which they pass through the beam.

Mold

In the next major step, (Step VII in Figure 1), leadframe 5—100, with 14 chips attached, is placed into a transfer or injection molding machine to mold plastic about it, thus encapsulating and protecting the chip. The molding process will be done using conventional techniques and equipment. It is an advatageous feature of this invention that the wide contact area between the leadframe and the contact pads is extremely rugged compared to the wire bonding technique that is in standard use so that a far smaller fraction of chips will be damaged during handling and the chips can be moved about at a greater rate and with less delicacy required. It is a further advantage that the leads conduct heat away from the chip during operation.

After the encapsulated dice, (still in the leadframe) are removed from the molding machine, the optional labelling step of Figure 2 is performed. The dice identity first appeared during probe test, when data were measured that applied to an individual die. That identity was preserved by the labels on the wafer, tape frame and leadframe, the computer being updated as required to log the die identity on the leadframe. Each chip may be marked by laser branding process or any other convenient technique with an identifying label, test results, etc.

The conventional "dejunk" step, in which excess plastic is removed from the leads is also performed at this time.

Trim/Form

Next, in step VIII of Figure 1, the chip plus leadframe combination is separated from the ribbon and the spacing segments 5—124 that served to maintain the leads in correct alignment are severed. If the ribbon is formed from a sheet of copper or copper alloy, it is necessary to sever the connections 5—124 or else all the leads will be shorted together. If another version of the ribbon is used, in which a plastic backing is used for the portion 5—110 and to support leads 5—120, on top of which a plated copper lead has been formed, then it will be easy to maintain the sections 5—124 in plastic and it is not necessary to separate the leads.

Leadframe detail

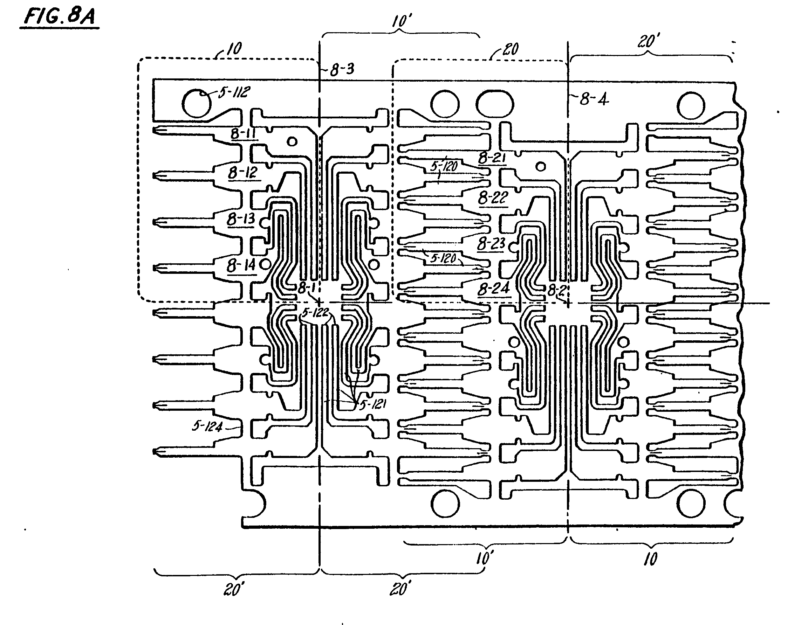

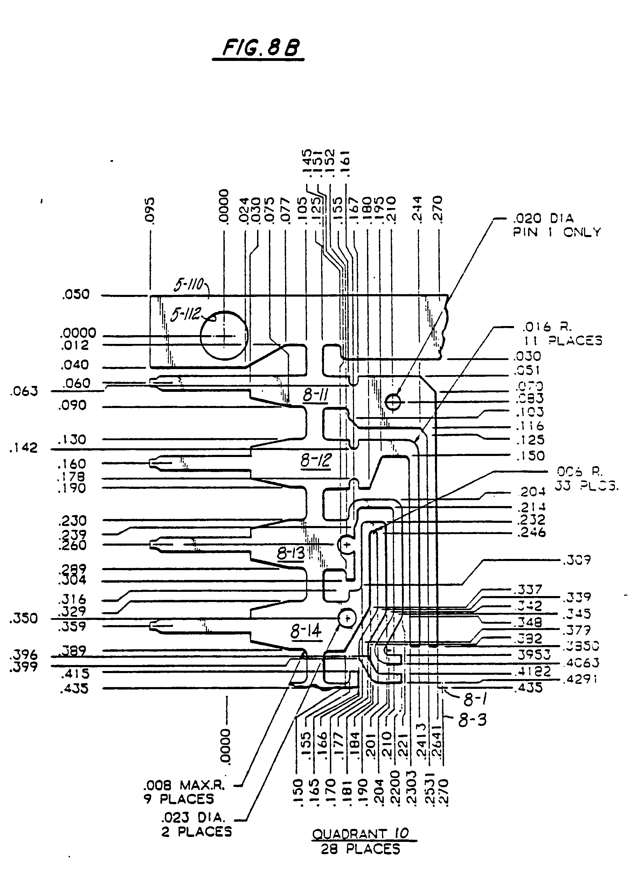

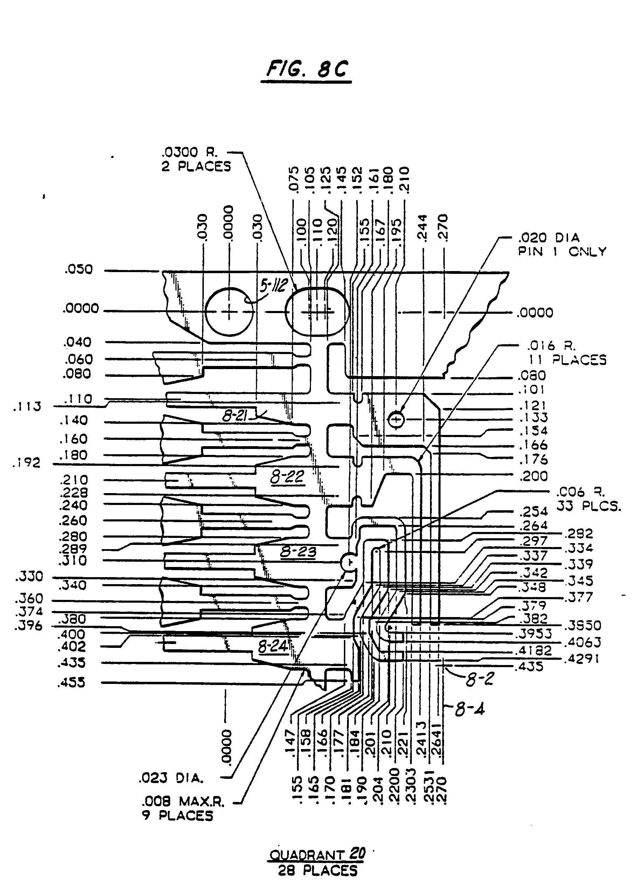

The illustration in Figure 5 is general in nature, for the purpose of illustrating the broadest version of leadframe to die bonding principles usable in the invention. More leadframe detail is shown in Figure 8, in which Figure 8A is a top view of a portion of a leadframe strip containing two leadframes centered on points 1 and 2 respectively.

The figure is crowded because of one advantageous feature of the invention, which is that the exterior portion 5—121 of adjacent leadframes overlap ("interdigitated" in conventional terminology), thus reducing the amount of scrap that is produced when the leads are stamped or etched out of the metal ribbon. It would also be simple to overlap the portions 5—121 by offsetting every other leadframe by one half the distance between leads 5—120, but then the chip location in the fixture would also have to be offset, which would make the die loading into the fixture process more complex.

Each 16-pin leadframe is formed from four quadrants 10, 10', 20 and 20', Quadrants 10 and 10', are mirror images reflected through centerlines 8—3 or 8—4; as are quadrants 20 and 20'. The difference between quadrants 10 and 20 is the shape of fingers 5—121 that extend from joining strips 5—124 to contact pads 5—122 of the individual leads. Two sets of four leads 8—11 to 8—14 and 8—21 to 8—24 are shown in Figure 8A and in more detail in Figures 8B and 8C, respectively.

In order to show the most complete details of the leadframe, the pertinent portions of working drawings have been reproduced. The numerals with a decimal point are dimensions in inches in a rectangular coordinate system having its origin at the center of hole 5—112. For example, finger 8—11 of quandrant 10 has a width of 6.6 millimeters - 6.3 millimeters or .3 millimeter (0.2641 inch - 0.2531 inch or 0.011 inch) and is separated from finger 12 by 6.3 millimeters - 6.0 millimeters or .3 millimeter (0.2531 inch - 0.2413 inch or 0.012 inch).

Fingers 5—121 have been designed to have the same spring constant; in this embodiment 0.025 mm deflection for 981 dynes, (1 to 2 grams force per 25 micrometers (1-mil) of deflection) in order to ensure reliable contact between finger tip 5—122 and pad 342. Tips 5—122 are formed by bending fingers 5—121 with a radius of curvature of .25 millimeter (0.010 inch), resulting in a contact tip that is nominally .25 millimeter (0.01 inch) square.

The particular leadframe illustrated has external leads 5—120 conforming to industry standards for a 16-pin D.I.P. The material is OLIN 195(Registred Trade Mark), 3/4 hard, with thickness .25+.013 millimeter (0.010 + 0.0005 inch) before plating. The solder plating is tin-lead 200—350 microinches thick, with a tin content between 88% and 98%, the balance lead.

Centerlines 8—3 and 8—4 of Figure 8A are separated by 13.8 millimeters (0.540 inch), resulting in a set of 14 leadframes that has an overall length of 19.4 centimeters (7.75 inches).

Many other designs for fingers 5—121 can be made by those skilled in the art in the light of this disclosure. It is not essential for the practice of the invention that fingers 5—121 have exactly the same spring constant and substantial variations is permissible.

Handling the leadframes presents a difficult challenge. They are fragile and would easily be crushed by conventional grippers. Grippers with "tactile" sensors might be used, but they are expensive. Vacuum lifters cannot be used because of the many apertures in the leadframe.

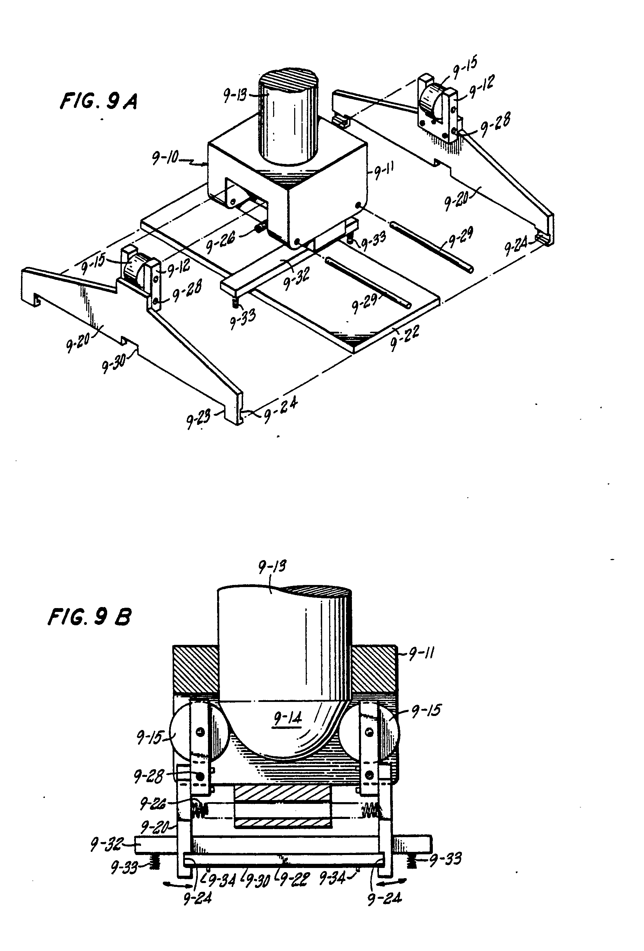

Figures 9A and 9B illustrates an economical gripping fixture that handles the task of lifting and aligning the leadframe. Figure 9A is an exploded view and Figure 9B is a side view of an assembled fixture. Referring now to Figure 9B, the principle that has been adopted is the use of a "back-up bar" 9—22 to relieve the pressure that gripping fixtures 9—20 would otherwise exert. The force arises from spring 9—26, shown as connected between grippers 9—20 and pressing them apart. Other springs in different locations or other methods of exerting force may also be used.

Leadframe 9—30 is located below bar 9—22 and between notches 9—24 in extensions 9—23 of gripping fixtures 9—20. As can be seen in Figure 9A, there are four notches 9—24. There is a nominal clearance of .37 millimeter (.015 inch) between the bottom of bar 9—22 and the bottom of notch 9—24. Since leadframe 9—30 is only .25 millimeter (0.010 inch) thick, there is a margin of 125 millimeters (.005 inch).

Gripping fixtures 9—20 pivot about pivots 9—29 in response to downward pressure from cone 9—14 on rollers 9—15 attached to fixtures 9—20. Come 9—14 is illustratively part of a commercially available air actuated cylinder with spring return, 9—10, available from the Seiko corporation. Housing 9—11 encloses cylinder 9—13, having cone 9—14 on the lower end, and provides support for pivots 9—29 through hole ends 9—28 on arms 9—12. There are four hole ends 9—28 that support both ends of each pivot 9—29. Housing 9—11 also supports bar 9—22 through a rigid support that is omitted from Figure 17 for clarity. The motion of gripping fixture 9—20 is indicated by the arrows in Figure 9B, and also by the top section of Figure 9A, which shows levers 9—15' deflected downward by cone 9—14.

Slots 9—30 in fixtures 9—20, visible in Figure 17A, provide clearance for spring-loaded plungers 9—33, shown schematically in the figures, as being supported by support bar 9—32 fastened to backup bar 9—22. The function of plungers 9—33 is to press against lower bond fixture 7—112 to prevent backup bar 9—22 from being held by its alignment pins to the bonding fixture.

Two alignment pins, 9—34, are shown in Figure 9B. Pins 9—34 are lokated on diagonally opposite corners of bar 9—22 in order to locate bonding fixture 7—112 with respect to bar 9—22. This alignment does not align the leadframe with respect to the bonding fixture or with the dice because the holes in the leadframe through which pins 9—34 pass are oversized. That alignment is effected by pins in the bonding fixture, not shown in the drawing, that enter selected holes in the leadframe. The bonding fixture, leadframe and gripper combination must be within a tolerance range before the alignment pins in the bonding fixture will enter the proper holes in the leadframe, of course, and that is the function of pins 9—34. There will always be errors in the exact location of pins and holes and pins 9—34 may bind in their mating holes. Plungers 9—33 are used to ensure disengagement of pins 9—34 from the bonding fixture. Leadframe 9—30 remains with the bonding fixture because the holes in the leadframe through which pins 9—34 pass have a looser tolerance than the four holes that mate with alignment pins in the bonding fixture. The combination of four pins and tighter tolerance ensures that leadframe 9—30 is held fast when the gripper is lifted.

Discrete component attachment

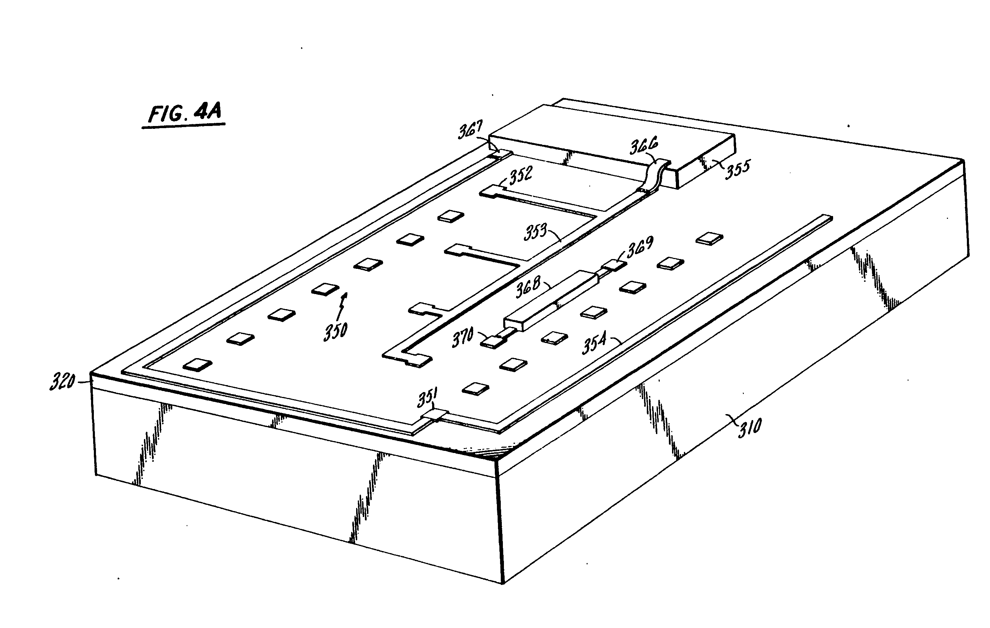

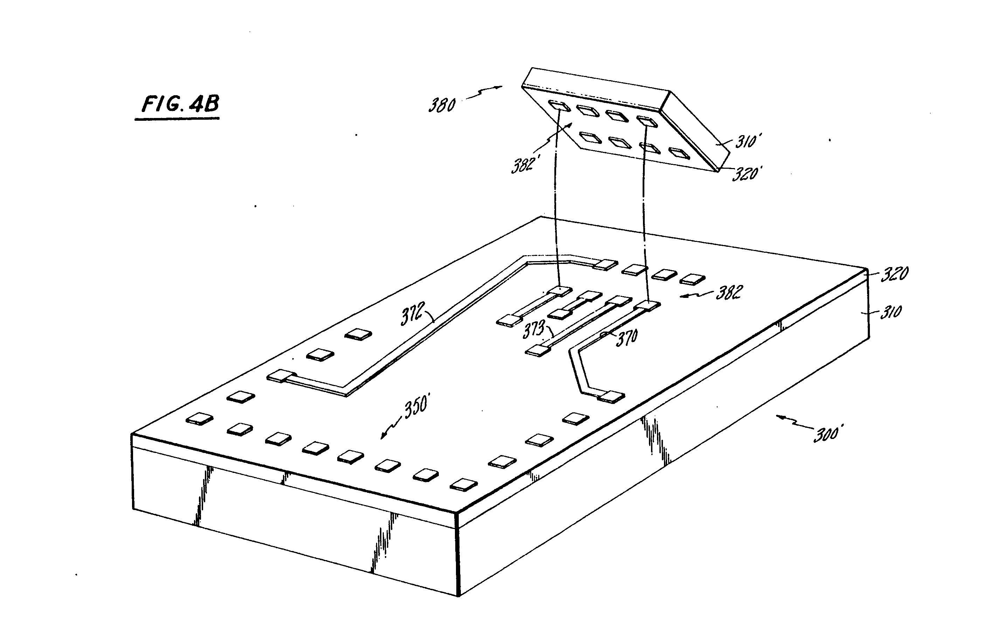

Referring now to Figures 4A and 4B, there is shown a variation of a die using the standard pad layout. The standard pad array of Figures 3A and 3B used a square outline that was sized to fit on a very small chip, so that a single leadframe could be used for the complete size range. There may be other technical or economic considerations, however, that justify a different pad array (which may still be common to a number of integrated circuits).

For example, Figure 4A shows a die having the same substrate 310 and polyimide 320 as before, but in which the pad array comprises two rows 350 illustratively of eight pads each, set toward the outside of the chip. With the center clear, there is room for bus 353, which distributes the power supply voltage to various points in the circuit, one of which is a via indicated by the numeral 352 and positioned at one of the array positions to make contact with a lead. Compared with the prior art technique of using thin wires bus 353 offers considerably less resistance and inductance. Similarly, bus 354 makes contact with pad 351 and distributes the ground terminal about the die.

A further advantage of the sturdy polyimide layer 320 is that discrete electrical devices, active or passive, may be placed on top of layer 320 and connected to the circuit, either by vias or to the standard pads. In Figure 4A, device 368 is shown as being connected to vias 370 and 369. The device may be a thick-film resistor having a large magnitude (that is difficult to achieve with conventional integrated circuit techniques). It also may be a separately formed device, optionally with conventional surface-mounted-device packaging. Examples are resistors, inductors and capacitors.

One useful example of a capacitor is shown as unit 355, a charge reserve capacitor connected between the power supply and ground using a conductive adhesive at point 367 and to strap 366. Such capacitors are conventionally attached to integrated-circuit sockets to maintain a stable supply voltage when circuits switch. The economic advantages of including the capacitor with the chip are evident. A device such as unit 355 may be connected to any point in the circuit, of course.

One variation that is of great interest is the use of a separate device 355 that is an optical or other element that is difficult to fabricate on the same substrate. For example, device 355 could be a solid-state laser using a gallium arsenide substrate and die 310 could be a conventional silicon integrated circuit. In that case, a fiber-optic pigtail would be included for communication to other optical devices.

Other devices that may be readily implemented are an R—C timing network, either fixed or having an adjustable element for which an access hole is formed in the encapsulating plastic; or a power transistor using the area of device 355 to spread the heat load. Heat sinks may also be attached directly to layer 320 or to vias that provide a low impedance thermal conduction path from high-power sections of substrate 310.

These other devices may be attached in any convenient manner. They may be adhesively attached before or after the soldering of the leadframe (or they may be soldered and the leadframe adhesively attached). Alternatively, soldering or gluing of leadframe and discrete devices may be done simultaneously, with the leadframe maintained in position prior to bonding by an adhesive.

Figure 4B illustrates another variation of the invention that offers considerable reduction in inventory. There is now a two-chip assembly comprising a first chip 300' having substrate 310, polyimide 320 and surface pads as before, and a second chip 380 comprising substrate 310', polyimide 320' and array of contacts 382' that mate with an array of contacts 382 on layer 320.

An alternate U-shaped contact array 350' is shown, which has the advantage of freeing up half of layer 320 for chip 380. In order to bring all the leads over to one half of chip 300', it may be necessary to permit some variation in the spring constant of the leads.

Only some connections between contacts 350' and 382 are shown, for power supply and ground. Chip 380 may connect directly to the leads for input/output, of course. In the case illustrated, chip 382 is a ROM that needs only power supply and ground and communicates only with the larger chip through vias in array 382 or through surface leads, such as lead 373.

One particular application of great commercial interest is that of a multi-purpose chip, such as a single-chip microcomputer that is customized by adding a ROM. If the ROM is a mask option, then there must be a reserve supply of customized microcomputers to allow for fluctuations in the yield, or rush orders and the manufacturer must maintain an inventory of chips that are good only for one customer. With the embodiment of Figure 3D, however, the inventory for each customer need only be his ROMs, which are much cheaper than microcomputers. The manufacturer will maintain a reserve of microcomputer chips sufficient to meet the needs of all his customers of course. It is evident that the total value of inventory will be less with a central reserve, simply because of the laws of statistics.

A variation of the two-chip system is that in which the main chip 302 is a generalized system, such as an input controller and the second chip 380 is one of a number of alternatives, each customized for a particular application. For example, the main chip might be a 5-volt logic chip and chip 380 might be designed to withstand the high voltages of the telephone network in a telephone interface such as a modem or coder.

Many other applications of the second chip, such as interfaces to different manufacturers' computers for plug-compatible systems; or the implementation of one of a number of standard logical functions, such as a parallel output or a serial output, will be evident to those skilled in the art.

One convenient method of attaching chip 380 is to form pads 382' with a sufficient amount of high temperature solder to make reliable contact and to reflow that bond before bonding the leads at a lower temperature. Another method is to adhesively attach chip 380 in alignment and to solder both sets of contacts simultaneously.

Impedance-matched leads

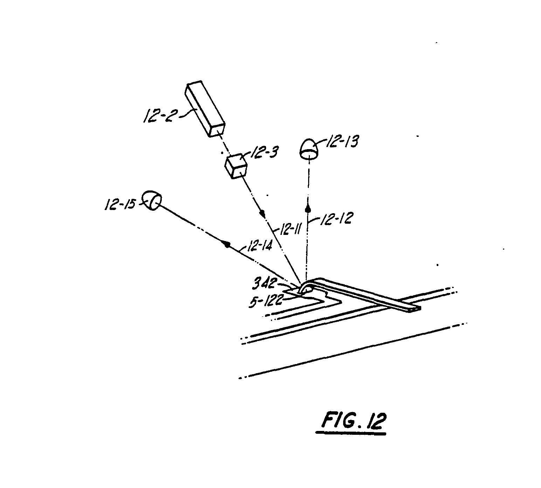

An alternate form of leadframe, shown in Figures 10 and 11, has the improved feature that the impedance of the leads is a particular value that is matched to the rest of the circuit in which the integrated circuit chip is inserted in order to improve the transmission of signals to and from the chip. The improved leadframe has the same general form as that shown in Figures 5 and 8. The major difference in constructuion is that the material of the leadframe is now a sandwich construction having two layers of conductor with a dielectric inbetween. The thickness of the dielectric and the shape of the leads are chosen to produce the desired impedance.

The reason for using a more complex lead structure is that, in high frequency integrated circuits, the fundamental frequency of a 1 nanosecond pulse is 1GHz and the bandwidth required to pass such a pulse cleanly is 13 GHz. In this high frequency regime, the packaging of the integrated circuit becomes a limiting factor and the rise time of the lead connecting the integrating circuit with the rest of the system limits the bandwidth of the circuit itself. A further problem of such high frequency systems is that an impedance mismatch between the printed circuit socket or other connector and the lead gives rise to reflections that can cause erroneous results when the circuits respond on a sub-nanosecond time scale.

With the present method of attaching integrated circuits by wire-bonding, a narrow wire having a diameter on the order of 1 mil is used to join the relatively wide leadframe to the integrated circuit chip. Such a narrow diameter wire, of course, has a high inductance associated with it and the impedance mismatch between the wire and the leadframe gives rise to reflections and also to a bandwidth limitation.

Referring now to Figure 10A, there is shown a portion of a lead indicated generally by the numeral 5—120, referring to the external portion of the lead in Figure 5. The lead tip is shown comprising a sandwich of a first conductor 10—2, the dielectric 10—6 and the other conductor 10—4. This lead tip is shown above a socket having a first side 10—1 and a second side 10—3 which make electrical contact with the respective conductor layers of the lead tip. One of these electrical conductors will be the ground and the other will carry the signal. The socket is shaped to match the impedance of the lead. Optionally, sides 10—1 and/or 10—3 may have spring action or be pressed by spring members not shown to provide reliable mechanical contact with the lead. Fabrication of this "sandwich" construction is straightforward. Illustratively, the overall leadframe is formed from a sheet of polyimide, laminated between two conductors and the leads are shaped by stamping or etching.

The standard strip transmission line formula is $Z = 120\pi/(\varepsilon_r S/W)$; where $\varepsilon_r$ is the dielectric constant, S is the separation of the two conductors and W is the width of the lead. Application of this formula to an example in which the width is 0.25 millimeter (10 mils); the thickness of the dielectric is 0.125 millimeter (5 mils); and the material is polyimide, having a dielectric constant of 3.5; the characteristic impedance is calculated to be 50 ohms, which fits well with a commonly used impedance in RF circuits. Those skilled in the art will readily be able to devise different lead constructions for differeent desired values of impedance.

Referring now to Figure 10B, the tip 5—122 (the "die tip") of lead 5—121 is shown, in which members 10—22 and 10—24 are the conductors 10—2 and 10—4, bent to provide for easy attachment to contacts on the integrated circuit chip. Suitable contacts, shown as 10—32 and 10—34 are pre-tinned contact pads constructed as indicated above in the description of Figure 3. The transmission line lead 5—122 is terminated by resistor 10—35, which is a discrete resistor formed by thick-film techniques, having the same impedance as the transmission line.

This same attachment technique may be used on the external tips 5—120 of the leadframe if the chip is to be used in a surface mounted device configuration.

Referring now to Figure 11, a single lead 8—22 from Figure 8 is shown, having external lead tip 5—120 and lead die tip 5—121. In this case, in order to provide the maximum smoothness in impedance change and the minimum amount of reflections, a single width strip conductor 11—12 having the same width throughout is used. The body 11—10 of this area of lead 8—22 is formed from the dielectric (10—6 in Figure 10A) and the single narrow strip 11—12 is formed from the conductor. In this way, the reflections and impedance changes that would result from changing the shape of the transmission line are avoided. An additional benefit is that since the segment 5—124 which has to be trimmed away in the embodiment of Figure 5, is now dielectric, that trimming step may be eliminated, since the leads may remain attached to one another by the plastic with no adverse effect on signal propagation. It is not necessary that a single-width strip be used, and the cross section of the strip may vary, subject to the requirements imposed the bandwidth of the packaging material by the system application in question.

It is not necessary for the practice of the invention that the impedance-matched leads have the form shown in the drawings and many other embodiments within the scope of the appended claims are possible. In particular, it is not necessary in order to practice this invention that the attachment portions of the leads be shaped to have the same spring constant. It is also not necessary that the leadframe be adapted to the standard pad array that has been described above. It is also not necessary that the leadframe be adpated for a dual in line lead configuration. A single in line configuration, among others, may also use this invention.

**Claims**

1. A leadframe for an integrated circuit comprising:
— at least one lead array of electrically conductive leads (5—120), each of said leads having an external portion (5—123) for connection to devices external to said integrated circuit and an attachment portion (5—122) for providing a connection to a contact on a semiconductor chip; and
— at least two positioning members (5—124), each attached to at least one lead of said array of leads between said external portion and said attachment portion, whereby said attachment portions of said array of leads are maintained in predetermined positions prior to attachment to a semiconductor chip and said external portions of said array of leads are maintained in a configuration adapted for external attachment; characterised in that:
at least one of said electrically conductive leads is a strip transmission line formed by first and second conductors (10—2, 10—4) bonded to opposite sides of an intermediate dielectric (10—6), said dielectric having a dielectric thickness and said first and second conductor having a conductor width such that said transmission line has a predetermined impedance: and
— said attachement portion (5—122) of said strip transmission line terminates in an attachment in which said first and second conductors bend to form corresponding first and second coplanar attachment tips (10—22, 10—24) adapted for bonding to contacts (10—32, 10—34) on said semiconductor chip.

2. A leadframe according to claim 1, further characterised in that said at least two positioning member (5—124) are formed from said intermediate dielectric, each connecting adjacent leads of said lead array.

3. A leadframe according to claim 1, in which said external portion (5—123) of said strip transmission line terminates in an external end in which said first and second conductors bend to form corresponding first and second coplanar attachment tips adapted for surface-mounted bonding.

4. A socket for an integrated circuit, said socket having an array of connectors adapted for receiving leads of an integrated circuit package, the package comprising the lead frame as defined in claim 1, comprising:
— each of said array of connectors having (10—6') a pair of conductors (10—1, 10—3) separated by a dielectric material being shaped and sized to form a strip transmission line having a predetermined impedance matched with the impedance of the lead frame; and
— one conductor of at least some of said connector array being connected to a common terminal.

5. A socket according to claim 4, in which the pair of conductors for each array of connectors extends past the dielectric material, forming a gap therebetween for the mechanical insertion of an integrated circuit lead.

**Patentansprüche**

1. Leiterrahmen für eine integrierte Schaltung mit
— wenigstens einer Leiteranordnung aus elektrisch leitfähigen Leitern (5—120), von welchen jeder Leiter einen Außenteil (5—123) zur Verbindung mit Vorrichtungen außerhalb der integrierten Schaltung und einen Befestigungsteil (5—122) zum Herstellen einer Verbindung mit einem Kontakt auf einem Halbleiterchip aufweist, und
— wenigstens zwei Positionierungselementen (5—124), die jeweils an wenigstens einem Leiter der Leiteranordnung zwischen dem Außenteil und dem Befestigungsteil befestigt sind, wodurch die Befestigungsteile der Leiteranordnung von der Befestigung an einem Halbleiterchip in vorbestimmten Positionen gehalten sind und die Außenteile der Leiteranordnung in einer zum Außenanschluß geeigneten Konfiguration gehalten sind, dadurch gekennzeichnet, daß wenigstens einer der elektrisch leitfähigen Leiter eine aus einer ersten und einer zweiten Leiterbahn (10—2, 10—4) ausgebildete Streifenübertragungsleitung ist, die an gegenüberliegende Seiten eines dazwischenliegenden Dielektrikums (10—6) gebondet sind, wobei das Dielektrikum eine solche dielektrische Dicke aufweist und die erste und die zweite Leiterbahn eine solche Leiterbahnbreite aufweisen, daß die Übertragungsleitung eine vorbestimmte Impedanz aufweist, und daß der Befestigungsteil (5—122) der Streifenübertragungsleitung in eine Befestigung mündet, bei welcher sich die erste und die zweite Leiterbahn biegen, um entsprechende erste und zweite koplanare Befestigungsspitzen (10—22, 10—24) zum bilden, die zum Bonden an Kontakte (10—32, 10—34) des Halbleiterchips geeignet sind.

2. Leiterrahmen nach Anspruch 1, außerdem dadurch gekennzeichnet, daß wenigstens zwei Positionierungselemente (5—124) aus dem dazwischenliegenden Dielektrikum ausgebildet sind, wobei jedes nebeneinanderliegende Leiter der Leiteranordnung verbindet.

3. Leiterrahmen nach Anspruch 1, bei welchem der Außenteil (5—123) der Streifenübertragungsleitung in ein Außenende mündet, bei welchem sich die erste und die zweite Leiterbahn biegen, um entsprechende erste und zweite koplanare Befestigungsspitzen zu bilden, die sich zum Bonden in Oberflächenmontage eignen.

4. Buchse für eine integrierte Schaltung, mit einer Anordnung von Verbindern, die geeignet sind, die Leiter des Gehäuses einer integrierten Schaltung aufzunehmen, wobei das Gehäuse den Leiterrahmen aus Anspruch 1 aufweist, wobei jede Verbinderanordnung (10—6') zwei Leiterbahnen (10—1, 10—3) aufweist, die durch ein dielektrisches Material getrennt sind, das eine solche Form und Größe hat, daß es eine Streifenübertragungsleitung mit einer vorbestimmten Impedanz bildet, die an die Impedanz des Leiterrahmens angepaßt ist, und

wobei eine Leiterbahn von wenigstens einigen aus der Verbinderanordnung mit einem gemeinsamen Anschlußpunkt verbunden ist.

5. Buchse nach Anspruch 4, bei welcher die zwei Leiterbahnen für jede Verbinderanordnung an dem dielektrischen Material vorbei verlaufen, wobei sie dazwischen eine Lücke für das mechanische Einfügen eines Leiters einer integrierten Schaltung bilden.

## Revendications

1. Un cadre conducteur destiné à un circuit intégré comprenant:

— au moins un arrangement de conducteurs électriques (5—120), chacun des dits conducteurs possédant une portion externe (5—123) établissant une connexion avec des dispositifs externes audit circuit intégré et une portion de jonction (5—122) fournissant une connexion à un contact sur une plaquette de semiconducteur; et

— au moins deux éléments de positionnement (5—124), chacun étant fixé à au moins un conducteur dudit arrangement de conducteurs entre ladite portion externe et ladite portion de jonction, où lesdites portions de jonction dudit arrangement de conducteurs sont maintenues dans des emplacements prédéterminés avant d'être adjointes à une plaquette de semiconducteur et où lesdites portions externes dudit arrangement de conducteurs sont maintenues dans une configuration adaptée à la jonction externe, se caractérisant en ce que:

au moins un des conducteurs électriques est une ligne bande de transport d'énergie formée par des premier et second conducteur (10—2, 10—4) fixés aux côtes d'une diélectrique intermédiaire (10—6), ledit diélectrique possédant une épaisseur diélectrique et lesdits premier et second conducteurs ayant une largeur de conduction telle que ladite ligne de transmission à une impédance prédéterminée, et

— ladite portion de jonction (5—122) de ladite ligne bande de transmission se termine par une liason où lesdites premier et second conducteurs sont tordus de manière à former des première et seconde broches corresponantes de fixation coplanaires (10—22, 10—24) adaptées à former une liaison avec des contacts (10—32, 10—34) sur ladite plaquette de semiconducteur.

2. Un cadre conducteur selon la revendication 1, caractérisé en outre en ce que lesdits éléments de positionnement (5—124) au nombre minimum de deux sont formés à partir dudit diélectrique intermédiaire, chacun connectant des conducteurs adjacents dudit arrangement de conducteurs.

3. Un cadre conducteur selon la revendication 1, dans lequel ladite portion externe (5—123) de ladite ligne bande de transport se termine par une extrémité où lesdits premier et second conducteurs sont tordus de manière à former des broches correspondantes de première et second fixation coplanaires adaptées à la liaison par montage en surface.

4. Un socle de circuit intégré, ledit socle possédant une arrangement de connecteurs adaptés à la réception des conducteurs d'un boîtier de circuit intégré, le boîtier comprenant le cadre conducteur tel que défini dans la revendication 1, comprenant:

— chacun dudit arrangement de connecteurs possédant (10—6') une paire de conducteurs (10—1, 10—3) séparés par une matériau diélectrique formé et dimensionné de manière à former une ligne bande de transmission possédant une impédance prédéterminée, adaptée à l'impédance du cadre conducteur; et

— un conducteur d'au moins plusieurs dudit arrangement de connecteurs, étant relié à un terminal commun.

5. Un socle selon la revendication 4, dans lequel la paire de conducteurs de chaque arrangement de connecteurs dépasse le matériau diélectrique, formant un espace destiné à l'insertion mécanique d'un conducteur de circuit intégré.

## FIG. 1

```
        ┌─────────────┐
        │    FORM     │
  I ────│  STANDARD   │
        │  PAD ARRAY  │
        └─────────────┘
               │
               ▼
        ┌─────────────┐              ┌────────────────────┐
 II ────│ PROBE TEST  │◄════════════►│         /10        │
        └─────────────┘              │                    │
               │                     │                    │
               ▼                     │                    │
        ┌─────────────┐              │                    │
III ────│    SAW      │◄════════════►│                    │
        └─────────────┘              │                    │
               │                     │                    │
               ▼                     │      COMPUTER      │
        ┌─────────────┐              │                    │
 IV ────│ SELECT DICE │◄════════════►│                    │
        └─────────────┘              │                    │
               │                     │                    │
               ▼                     │                    │
        ┌─────────────┐              │                    │
  V ────│    BOND     │              │                    │
        └─────────────┘              │                    │
               │                     │                    │
               ▼                     │                    │
        ┌─────────────┐              │                    │
 VI ────│   INSPECT   │═════════════►│                    │
        └─────────────┘              └────────────────────┘
               │
               ▼
        ┌─────────────┐
VII ────│    MOLD     │
        └─────────────┘
               │
               ▼
        ┌─────────────┐
VIII────│  TRIM/FORM  │
        └─────────────┘
```

## FIG.2

I: WAFER INPUT → APPLY INSULATION → APPLY METAL → PATTERN METAL → PLATE METAL

II: MAP WAFER → BAR CODE WAFER

FILM ON FRAME → WAFER ON TAPE

III: BAR CODE TO FRAME → SAW AND WASH → SAW INSPECT

IV: PICK DOWN → DIE PLACE

LEADFRAME

V: LEADFRAME FIXTURE ASSEMBLE → LEADFRAME BOND → LEADFRAME FIXTURE DISASSEMBLE

BONDING FIXTURE RETURN

PLASTIC IN → AUTO MOLD

VII: CHIP LABEL

VI: LEADFRAME INSPECT

VIII: TRIM AND FORM

FRAME RETURN

FIG.3A

FIG. 3B

344

348

343

350

320

310

300'

EP 0 176 557 B1

FIG. 4A

FIG.4B

FIG. 5

FIG. 6

FIG. 7

FIG.8A

10

## FIG. 8 B

## FIG. 8C

QUADRANT 20
28 PLACES

FIG. 9 A

FIG. 9 B

FIG. 10 A

FIG. 10 B

FIG. 11

*FIG. 12*